# EUROPEAN PATENT APPLICATION

(11) **EP 4 249 800 A1**
(43) Date of publication of application: **27.09.2023**
(21) Application number: 22164079.0
(22) Date of filing: 24.03.2022
(51) Int. Cl.: F21V 21/35, H01R 25/14, H01R 25/16, H05K 1/02

(54) **A LED TRUNKING LIGHTING SYSTEM**

(71) Applicant: Tridonic GmbH & Co. KG, 6851 Dornbirn (AT)
(72) Inventor: Becker, Markus, 6850 Dornbirn (AT); Lochmann, Frank, 6850 Dornbirn (AT)
(74) Representative: Rupp, Christian

(57) **Abstract**

The invention relates to a LED trunking lighting system, comprising: a preferably linear U-shaped or D-shaped profile carrying electrical power supply means, wherein the profile is designed for releasably mounting a load in electrical contact with said electrical power supply means, and at least one pair of twisted communication wires which are arranged at the inner side of the said profile and exposed for being contacted in defined discrete increments along the extension of the profile.

## Description

### TECHNICAL FIELD OF THE INVENTION

The invention relates to a LED trunking lighting system.

### BACKGROUND OF THE INVENTION

Lighting trunking systems (also called "LED linear trunking systems") are known as such and comprise trunking rails or profiles that can be mounted in long lines, e.g. to the ceiling of a room. A plurality of lighting modules or other devices can be attached to these trunking rails or profiles and connected to an electrical supply line of the system.

Often, communication lines are arranged along the trunking profile for connecting to the attached modules and devices. These communication lines can be Ethernet twisted pair cables.

However, Ethernet twisted pair cables are difficult to handle in trunking lighting systems and are quite inflexible, especially when changing the location of connected equipment on the trunking profile. For example, shortening of such cables requires manual cutting and crimping which is quite laborious. Once the cable is cut the location of an Ethernet port for connecting to a device is determined. In addition, a large number of cables, e.g. for connecting to a plurality of attached devices, is difficult to handle spatially in a single trunking profile.

As an alternative to Ethernet communication lines, powerline can be used to communicate with the device on a trunking system. However, using powerline requires expensive dedicated equipment and may lead to electromagnetic compatibility issues.

Thus, it is an objective to provide an improved trunking lighting system.

### SUMMARY OF THE INVENTION

The object of the present invention is achieved by the solution provided in the enclosed independent claims. Advantageous implementations of the present invention are further defined in the dependent claims.

According to a first aspect of the invention, a LED trunking lighting system is provided. The LED trunking lighting system comprises: a preferably linear U-shaped or D-shaped profile carrying electrical power supply means, wherein the profile is designed for releasably mounting a an electric load, such as e.g. a lighting module, in electrical contact with said electrical power supply means, and at least one pair of twisted communication wires which are arranged at the inner side of the said profile and exposed for being contacted in defined discrete increments along the extension of the profile.

The load can be e.g. a lighting means, microphone, camera or loudspeaker, sensors, actors,...

The twisted communication wires are arranged along the e.g. U or D-shaped profile of the trunking lighting system (Generally such profiles typically have to side walls connected to and angled vis-à-vis a connecting wall. The side walls and/or the connecting wall may be plane or curved). They are arranged to be exposed for the mechanical contact in defined discrete increments along the profile. The U or D-shaped profile can form a trunking rail that can be mounted to a ceiling of a room. The electrical power supply means can comprise a power supply line that is arranged along and/or mounted to the profile, e.g. for connecting to the electrically supplied load to supply them with electrical power.

This provides the advantage that multiple Ethernet devices can cheaply and flexibly be attached on a trunking lighting system.

In a preferred embodiment, the twisted communication wires are wires of an Ethernet connection, in particular of an Ethernet over twisted-pair or micro-strip connection.

In a preferred embodiment, the trunking lighting system comprises at least one PCB, printed circuit board, or at least one flextape mounted on or to the profile.

The PCB can comprise a substrate made from at least one dielectric layer. Preferably, the PCB is a multilayer PCB. Typically, the PCB substrate is rigid.

In particular, a flextape is a flexible PCB, i.e. a PCB with a flexible substrate made from at least one dielectric layer.

In a preferred embodiment, the PCB or the flextape comprises the twisted communication wires or micro-strip wires.

In a preferred embodiment, the twisted wires are formed by a pair of conductor traces that are alternately arranged on a first and a second layer of the PCB or flextape in a crisscrossing manner.

In particular, each one of the twisted wires can be formed by a respective conductor trace that is alternately arranged on the first layer and the second layer of the PCB or flextape. Here, alternately arranged means that respective conductor traces both alternate between the first and the second layer of the PCB respectively flextape, wherein the respective traces are thereby (mostly) arranged on the different layers of the PCB or flextape (i.e., if one trace is on the first layer, the other trace is on the second layer and vice versa). The additional crisscrossing orientation of the two conductor traces leads to a twisted arrangement of the conductor traces, essentially similar to twisted wire cables.

In a PCB or flextape made from a single layer, the conductor traces can be alternately arranged on a first and second side of the PCB or flextape.

In a preferred embodiment, the PCB or flextape comprises vias for electrically connecting the conductor traces on the first layer and the second layer to form continuous conductor traces.

In a preferred embodiment, the at least one PCB or the at least one flextape are mounted on the inner side of at least one of two side walls, or on the inner side of a top wall section of the profile.

In a preferred embodiment, the at least one PCB or the at least one flextape comprises contact pads in the defined discrete increments for mechanically contacting the twisted wires.

In a preferred embodiment, the contact pads are connectable to the load via an Ethernet port of the lighting trunking system.

The Ethernet port can be connected to the contact pads. For instance, the Ethernet port is plugged on the PCB or flextape.

In a preferred embodiment, the trunking lighting system comprises two or more PCBs or flextapes which are arranged along the profile of the lighting trunking system, wherein two neighboring PCBs or flextapes comprise matching connectors for interconnecting the PCBs or flextapes.

In particular, the connectors allow the continuation of the twisted wire pairs from one PCB (or flextape) to the connected PCB (or flextape).

In a preferred embodiment, the load comprises an LED module, e.g. one having a LED converter and LED lighting means.

The load, in particular the LED module, is connectable to the twisted communication wires or micro-strip wires via the mechanical contact.

In a preferred embodiment, the discrete increments are increments of 1 to 10 cm.

According to a second aspect, the invention relates to a system comprising a LED trunking lighting system and one or more LED based luminaires supplied by said electrical power supply means and connected to said communication wire pair.

### BRIEF DESCRIPTION OF THE DRAWINGS

The invention will be explained in the followings together with the figures.
- Fig. 1a-c: show a trunking lighting system according to an embodiment;
- Fig. 2: shows a top view of a PCB with exemplary twisted communication wires according to an embodiment;
- Fig. 3: shows two PCBs according to an embodiment; and
- Fig. 4: shows a PCB according to an embodiment.

### DETAILED DESCRIPTION OF THE PREFERRED EMBODIMENTS

Aspects of the present invention are described herein in the context of a trunking lighting system.

'LED luminaire' shall mean a luminaire with a light source comprising one or more LEDs or OLEDs. LEDs are well-known in the art, and therefore, will only briefly be discussed to provide a complete description of the invention.

All examples and embodiments that describe the configuration and arrangement of a PCB and its component in a lighting trunking system are equivalently valid for a flextape.

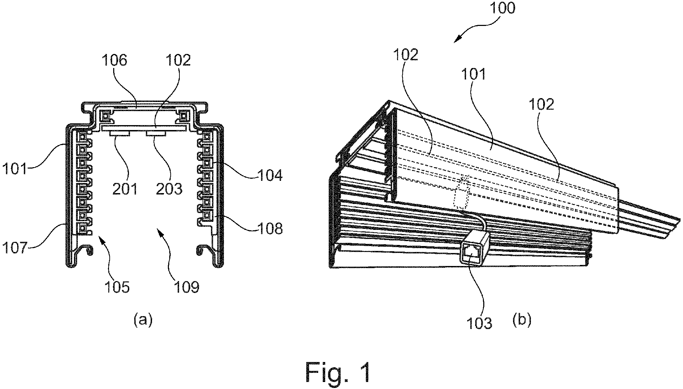

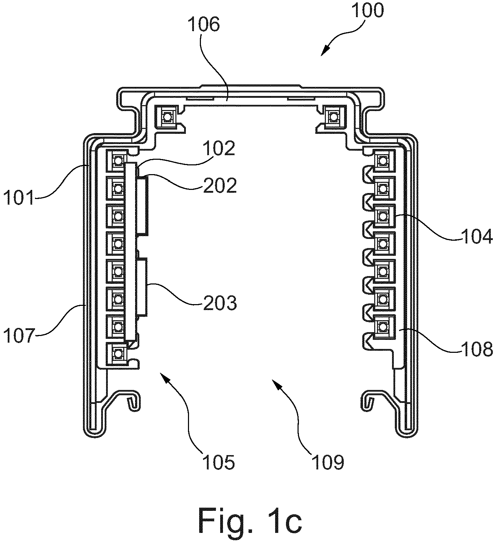

Now referring to Fig. 1, a LED trunking lighting system 100 is shown according to an embodiment.

In Fig. 1(a), a cross section of the LED trunking lighting system 100 is shown, while in Fig. 1(b) a lateral profile of the LED trunking lighting system 100 is shown.

The LED trunking lighting system 100 comprises: a profile 101 carrying electrical power supply means 104. The profile 101 is designed for releasably mounting an electrically supplied load in electrical contact with said electrical power supply means 104. In addition, the LED trunking lighting system comprises at least one pair of twisted communication wires 201 which are arranged at the inner side wall 105 of the said profile 101 and exposed to the outside for being contacted in defined discrete increments along the extension of the profile 101.

The load can be LED luminaires and/or LED modules.

The profile 101 can from an elongated rail.

The profile 101 shown in Fig. 1 is a linear profile which has a U-shaped cross section (linear U-shaped). E.g., the profile 101 comprises a connecting leg 106 on top and two side legs 107, 108 extending away from the connecting leg 106, which delimit an interior space 109 of the profile 101. The profile 101 can have an open longitudinal side (on the bottom), via which the interior space 109 is accessible, e.g. for releasably mounting the load 403.

The profile 101, in particular the two side legs 107, 108, can comprise a number of rails and other holding structures preferably on the inner side wall 105, e.g., for holding electrical power lines 104 or other wires.

Alternatively, the profile 101 can have a different shape, e.g. a linear D-shape.

The twisted communication wires 201, 203 can be arranged on the (top) connecting leg 106 of the profile 101. Alternatively or additionally, it can be arranged at the inner side wall 105 of one or even both side legs 107, 108 (see Fig. 1c).

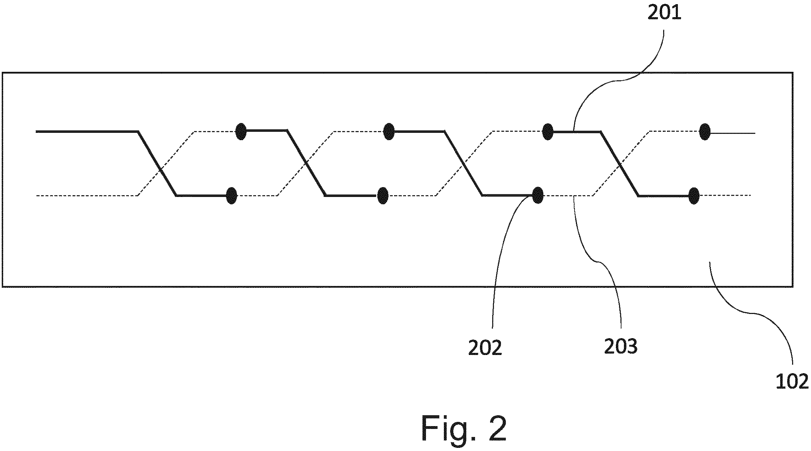

The twisted communication wires 201, 203 can be wires of an Ethernet connection, in particular of an Ethernet over twisted-pair connection as, e.g., shown in Fig. 2.

In particular, the trunking lighting system 100 can comprise at least one PCB 102, printed circuit board, or at least one flextape mounted on or to the profile 101. The PCB or flextable can comprise the twisted communication wires 201, 203. The PCB can be mounted to the top connecting leg 106 as shown in Fig. 1(a).

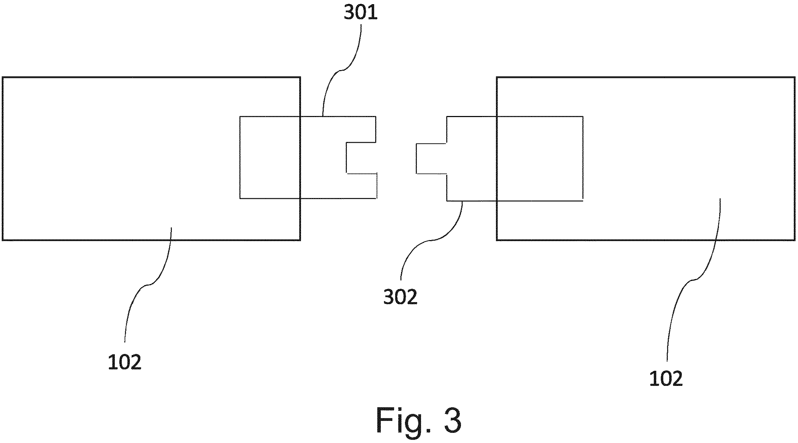

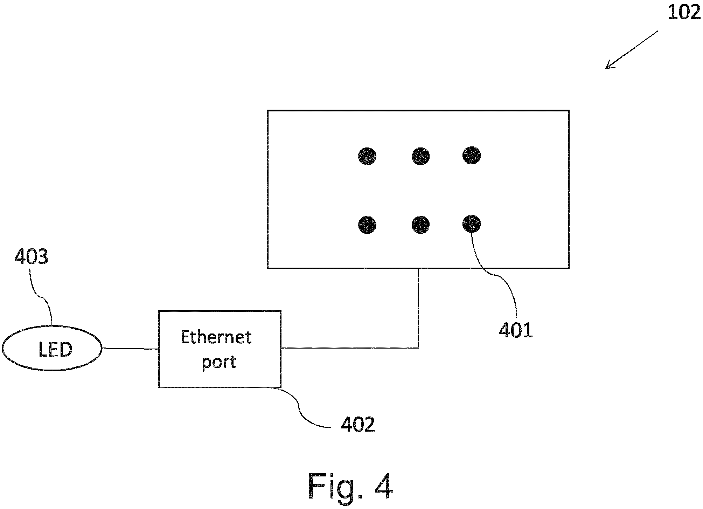

The lateral view of the profile 101 in Fig. 1(b) shows two PCBs 102 of the system 100 that are arranged along the profile 101. The PCBs can be interconnected (see Fig. 3 below). Furthermore, each PCB 102 can be connectable to the load via an Ethernet port 103 as indicated in Fig. 1(b) (see Fig. 4 below for more details).

Fig. 2 shows a top view of a PCB 102 with twisted communication wires 201, 203 according to an embodiment.

The twisted wires 201, 203 can be formed by a pair of conductor traces that are alternately arranged on a first and a second layer of a PCB 102. Preferably, the PCB 102 is a multiplayer PCB.

For instance, conductor traces 201, 203 start at the same layer or at different layers of the PCB 102 and alternate from between the layers. Thus, when one conductor trace 201 is on the first layer of the PCB, the other conductor trace 203 is on the second layer and vice versa.

The first and the second layer of the PCB 102 can be arranged on top of each other, e.g. the first layer forms a lower layer and the second layer forms an upper layer of the PCB substrate.

The PCB 102 preferably comprises vias 202 for electrically connecting the conductor traces on the first and the second layer to form continuous conductor traces. Thus, the two conductor traces 201, 203 can alternate between the layers. For example, the vias can be formed in the upper PCB layer to connect a conductor trace on the upper layer with the respective conductor trace on the lower layer and vice versa.

The two conductor traces 201, 203 on the different PCB layers crisscross each other to achieve a twisted configuration.

Such an arrangement of conductor traces on a PCB is, for instance, disclosed in document US 5,646,368, the disclosure of which is herein incorporated by reference in its entirety.

For instance, a typical width of one conductive trace can be 0.5mm and of one conductive trace pair can be 1.4mm. A trace pair according to a 100basetx Ethernet standard has a width of 2.8mm. Thus, a PCB or flextape with a width of 3cm can carry ca. 10 trace pairs according to the 100basetx Ethernet standard.

Fig. 3 shows two PCBs according to an embodiment.

The trunking lighting system 100 can comprise two or more PCBs 102 which are arranged along the profile 101 of the lighting trunking system 100. Thereby, two neighboring PCBs 102 can comprise matching connectors 301, 302 for interconnecting the PCBs 102.

The matching connectors 301, 302 can form a Board-2-Board Interconnect for transferring signals (e.g., communication signals or power signals) on the connection lines of one PCB to the next PCB.

The PCBs 102 can have a length of up to 1,2m. The total maximal length of interconnected PCBs 102 can be up to 100m. In particular, each PCB 102 can comprise two or four layers. Each PCB 102 can comprise two pairs or four pairs of twisted communication wires according to an Ethernet standard, e.g. 10BASE-T and 100BaseTX, or 1000BaseT. The number of pairs can be multiplied by the number of devices on a trunking section. Each PCB 102 can further comprise a ground trace. The PCB 102 can have an impedance of 100 Ohm.

If a flextape is used instead of a rigid PCB 102, the flextape can also be cut to a suitable length from a longer tape and/or several flextapes can be connected via the matching connectors 301, 302 on the tapes.

Fig. 4 shows a PCB 102 according to an embodiment.

The at least one PCB 102 or the at least one flextape can comprise contact pads 401 in the defined discrete increments for mechanically contacting the twisted wires 201 or micro-strip wires. The contact pads can be bond pads.

Moreover, the contact pads 201 can be connectable to the load 403 via an Ethernet port 402 of the lighting trunking system 100. A suitable connection area of the Ethernet port can, for instance, be bonded to the contact pads 201.

All features of all embodiments described, shown and/or claimed herein can be combined with each other.

While various embodiments of the present invention have been described above, it should be understood that they have been presented by way of example only and not limitation. Numerous changes to the disclosed embodiments can be made in accordance with the disclosure herein without departing from the spirit of scope of the invention. Thus, the breadth and scope of the present invention should not be limited by any of the above-described embodiments. Rather, the scope of the invention should be defined in accordance with the following claims and their equivalence.

Although the invention has been illustrated and described with respect to one or more implementations, equivalent alternations and modifications will occur to those skilled in the art upon the reading of the understanding of the specification and the annexed drawings. In addition, while a particular feature of the invention may have been disclosed with respect to only of the several implementations, such features may be combined with one or more other features of the other implementations as may be desired and advantage for any given or particular application.

## Claims

1. A LED trunking lighting system (100), comprising:
- a preferably linear U-shaped or D-shaped profile (101) carrying electrical power supply means (104), wherein the profile (101) is designed for releasably mounting a load (403) in electrical contact with said electrical power supply means (104), and
- at least one pair of twisted communication wires (201) which are arranged at the inner side wall (105) of the said profile (101) and exposed for being contacted in defined discrete increments along the extension of the profile (101).

2. The trunking lighting system (100) of claim 1, wherein the twisted communication wires (201) are wires of an Ethernet connection, in particular of an Ethernet over twisted-pair or micro-strip connection.

3. The trunking lighting system (100) of claim 1 or 2, wherein the trunking lighting system (100) comprises at least one PCB, printed circuit board, (102) or at least one flextape mounted on or to the profile (101).

4. The trunking lighting system (100) of claim 3, wherein the PCB (102) or the flextape comprises the twisted communication wires (201) or micro-strip wires.

5. The trunking lighting system (100) of claim 3 or 4, wherein the twisted wires (201) are formed by a pair of conductor traces that are alternately arranged on a first layer and a second layer of the PCB (102) or flextape in a crisscrossing manner.

6. The trunking lighting system (100) of claim 5, wherein the PCB (102) or flextape comprises vias (202) for electrically connecting the conductor traces on the first layer and the second layer to form continuous conductor traces.

7. The trunking lighting system (100) of any one of claims 3 to 6, wherein the at least one PCB (102) or the at least one flextape are mounted on the inner side wall (105) of at least one of two side walls (107, 108), or on the inner side of a top wall section (106) of the profile (101).

8. The trunking lighting system (100) of any one of claims 3 to 7, wherein the at least one PCB (102) or the at least one flextape comprises contact pads (401) in the defined discrete increments for mechanically contacting the twisted wires (201) .

9. The trunking lighting system (100) of claim 8, wherein the contact pads (401) are connectable to the load (403) via an Ethernet port (402) of the lighting trunking system (100).

10. The trunking lighting system (100) of any one of claims 3 to 9, wherein the trunking lighting system (100) comprises two or more PCBs (102) which are arranged along the profile (101) of the lighting trunking system (100), wherein two neighboring PCBs (102) comprise matching connectors (301, 302) for interconnecting the PCBs (102).

11. The trunking lighting system (100) of any one of the preceding claims, wherein the load (403) comprises an LED module.

12. The trunking lighting system (100) of any one of the preceding claims, wherein the discrete increments are increments of 1 to 10 cm.

13. A system comprising a LED trunking lighting system (100) and one or more LED based luminaires supplied by said electrical power supply means and connected to said communication wire pair (201).
